# EUROPEAN PATENT APPLICATION

(11) **EP 4 838 071 A1**
(43) Date of publication of application: **11.11.2026**
(21) Application number: 26176738.8
(22) Date of filing: 05.05.2026
(51) Int. Cl.: F01P 11/02, F01P 11/06

(54) **FILTER MAINTENANCE TOOL SYSTEMS AND METHODS**

(30) Priority: 05.05.2025 US 202563800129 P
(71) Applicant: Hoffman Enclosures Inc., Anoka, MN 55303 (US)
(72) Inventor: Kundem, Jeshwanth Durga Sagar, Minneapolis (US); Speight, Jacob, Anoka (US); Walther, Jack, Anoka (US); Rozko, Timothy, Anoka (US); Archibald, Matthew R., Derry (US); Metzger, Darin, Anoka (US)
(74) Representative: Barker Brettell LLP

(57) **Abstract**

A filter maintenance tool (100) for maintaining a filter of a coolant distribution unit (CDU) in a datacenter includes a housing (126), a reservoir (124) secured to the housing, a powertrain (118) housed within the housing, and a power source (108) within the housing to power the powertrain. The filter maintenance tool also includes an air hose (102) extending from the housing to selectively supply compressed air to the filter of the CDU, a liquid fill hose (110) extending from the housing to selectively supply fluid to the filter of the CDU, and a liquid drain hose (112) extending from the housing to drain coolant from the filter of the CDU into the reservoir. Additionally, the filter maintenance tool includes a user interface (104) arranged on the housing to switch the filter maintenance tool between a fill mode and a drain mode for servicing the filter of the CDU.

## Description

### CROSS-REFERENCE TO RELATED APPLICATIONS

This application claims the benefit of U.S. Provisional Application No. 63/800,129, filed May 5, 2025, which is hereby incorporated by reference in its entirety.

### BACKGROUND

Filters may be used in coolant distribution units (CDUs) to mitigate the risk of contaminated fluid passing through the cooling system. However, in some examples, the filters may require scheduled maintenance (e.g., replacement, draining, cleaning, filling, etc.), which may be a time-consuming and inefficient process.

### SUMMARY

According to one aspect of the present disclosure, a filter maintenance tool for maintaining a filter of a coolant distribution unit (CDU) in a datacenter can be provided. The filter maintenance tool can include a housing. A reservoir can be secured to the housing. A powertrain can be housed within the housing. A power source can be within the housing to power the powertrain. An air hose can extend from the housing to selectively supply compressed air to the filter of the CDU. A liquid fill hose can extend from the housing to selectively supply fluid to the filter of the CDU. A liquid drain hose can extend from the housing to drain coolant from the filter of the CDU into the reservoir. A user interface can be arranged on the housing to switch the filter maintenance tool between a fill mode and a drain mode for servicing the filter of the CDU.

In some examples, the powertrain may include at least one of a motor, a pump, a compressor, or a turbine.

In some examples, the power source may be a battery.

In some examples, the filter maintenance tool may further include a filter arranged on the liquid drain hose to filter the fluid drained from the filter of the CDU.

In some examples, the filter maintenance tool may further include a sensor to monitor a characteristic of the fluid passing through at least one of the liquid fill hose or the liquid drain hose.

In some examples, the filter maintenance tool may further include a display arranged on the housing to display the characteristic monitored by the sensor.

In some examples, the characteristic may include at least one of temperature, pressure, or volume of the fluid.

In some examples, at least one of the air hose, the liquid fill hose, or the liquid drain hose may include a quick-connect fitting to removably connect to a corresponding fitting on the filter of the CDU.

According to another aspect of the present disclosure, a method of maintaining a filter of a coolant distribution unit (CDU) using a filter maintenance tool can be provided. The method can include connecting an air hose of the filter maintenance tool to a first fitting on the filter. The method can include connecting a liquid drain hose of the filter maintenance tool to a second fitting on the filter. The method can include activating an air compressor of the filter maintenance tool to pass pressurized air through the air hose and force fluid out of the filter through the liquid drain hose. The method can include collecting the fluid forced out of the filter in a reservoir of the filter maintenance tool.

In some examples, the method may further include disconnecting the air hose from the first fitting on the filter, connecting a liquid fill hose of the filter maintenance tool to the first fitting on the filter, and activating a pump of the filter maintenance tool to pass fluid from the reservoir through the liquid fill hose to fill the filter.

In some examples, the method may further include filtering the fluid forced out of the filter through a second filter arranged on the liquid drain hose before collecting the fluid in the reservoir.

In some examples, the method may further include switching the filter maintenance tool between a fill mode and a drain mode using a user interface arranged on the filter maintenance tool.

In some examples, the reservoir may include a first reservoir portion and a second reservoir portion separated by a wall.

In some examples, the method may further include collecting the fluid forced out of the filter in the second reservoir portion and supplying fluid to the filter from the first reservoir portion.

According to yet another aspect of the present disclosure, a fill and drain tool for coolant distribution units (CDUs) in a datacenter can be provided. The fill and drain tool can include a housing. A reservoir can be secured to the housing. A pump can be housed within the housing. A power source can be within the housing to power the pump. A fluid port can extend from the housing to connect to a CDU. A user interface can be arranged on the housing to switch the fill and drain tool between a fill mode and a drain mode. In the drain mode, the pump can create suction through the fluid port to draw fluid from the CDU into the reservoir. In the fill mode, the pump can drive fluid from the reservoir through the fluid port to fill the CDU.

In some examples, the fill and drain tool may further include a handle extending from the housing to configure the fill and drain tool as a handheld tool for transport by an operator.

In some examples, the fill and drain tool may further include a filter arranged between the fluid port and the reservoir to filter coolant drawn from the CDU before the coolant enters the reservoir.

In some examples, the fill and drain tool may further include a compressor housed within the housing and an air hose extending from the housing to selectively supply compressed air to the CDU. In a secondary drain mode, the compressor may pass pressurized air through the air hose to force fluid out of the CDU and into the reservoir via the fluid port.

In some examples, the fill and drain tool may further include a pressure gauge arranged on the housing to monitor pressure within a fluid circuit of the fill and drain tool.

In some examples, the reservoir may include a first reservoir portion and a second reservoir portion separated by a wall. The first reservoir portion may be configured to store coolant for filling the CDU and the second reservoir portion may be configured to store coolant drained from the CDU.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. The tool(s) and/or or any feature(s) or component(s) described may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate embodiments of the invention and, together with the description, serve to explain the principles of embodiments of the invention:
FIG. 1 is a diagrammatic view of a filter maintenance tool according to aspects of the present disclosure.
FIG. 2 is an axonometric view of an example of a filter maintenance tool.
FIG. 3 is top view of the tool of FIG. 2.
FIG. 4 is a cross-sectional view of the tool of FIG. 2.
FIG. 5 is an axonometric view of a hose portion of the tool of FIG, with a portion of a hose rendered transparent for ease of illustration.
FIG. 6 is a first axonometric view of another example of a filter maintenance tool.
FIG. 7 is a second axonometric view of the tool of FIG. 6.
FIG. 8 is side view of the tool of FIG. 6.
FIG. 9 is a first cross-sectional view of the tool of FIG. 6.
FIG. 10 is a second cross-sectional view of the tool of FIG. 6.
FIG. 11 is a third cross-sectional view of the tool of FIG. 6.
FIG. 12 is an axonometric view of another example of a filter maintenance tool.
FIG. 13 is a cross-sectional view of the tool of FIG. 12.
FIG. 14 is a schematic illustrating one example of a filter maintenance tool according to aspects of the present disclosure.

### DETAILED DESCRIPTION

The following discussion is presented to enable a person skilled in the art to make and use embodiments of the invention. Given the benefit of this disclosure, various modifications to the illustrated embodiments will be readily apparent to those skilled in the art, and the principles herein can be applied to other embodiments and applications without departing from embodiments of the invention. Thus, embodiments of the invention are not intended to be limited to embodiments shown, but are to be accorded the widest scope consistent with the principles and features disclosed herein.

The following detailed description is to be read with reference to the figures, in which like elements in different figures have like reference numerals. The figures, which are not necessarily to scale, depict selected embodiments and are not intended to limit the scope of embodiments of the invention. Skilled artisans will recognize the examples provided herein have many useful alternatives and fall within the scope of embodiments of the invention.

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

In some examples, a filter maintenance tool may be used to assist operators in maintaining filters, particularly within data center environments. The tool may be available in handheld or backpack-style configurations, the tool offers both automated and manual options for draining and filling filters.

In some examples, the housing of the tool includes a powertrain (motor, pump, compressor, turbine, etc. ) and a power source (rechargeable battery, AC power connection, etc.). Further, the tool may include a reservoir for fluid storage, which can be designed as a single compartment or divided into separate sections, with one section used for fresh fluid and a second section used for used fluid.

In some examples, the tool includes an air hose that supplies compressed air for draining operations, a liquid fill hose that delivers fluid from the reservoir to the filter, and a liquid drain hose that channels fluid from the filter into the reservoir. In some examples, to transition the tool between fill and drain modes, the tool may include a user interface Further, the tool may have one or more displays showing real-time data on fluid characteristics such as temperature, pressure, volume, etc., while integrated sensors continuously monitor fluid properties during operation. Quick-connect fittings, which may be interchangeable to accommodate different filter ports, facilitate versatility across various filter types. In some examples, a filter installed on the drain hose filters fluid before it enters the reservoir, permitting reuse of drained fluid and reducing waste.

As mentioned above, in some examples, the tool functions in two primary modes. In the drain mode, compressed air forces fluid out of the filter through the drain hose and into the reservoir. In the fill mode, a pump drives fluid from the reservoir through the fill hose into the filter. Thus, a single, portable, tool may be used for both fill and drain operations, which may increase efficiency when performing maintenance on the large number of filters in a datacenter.

In some examples, for larger-scale operations, the backpack-style tool provides increased capacity and enhanced portability with features like adjustable straps, a larger reservoir with a fill cap, and an angled drain port for convenient emptying. This configuration allows maintenance personnel to move freely throughout facilities while carrying all necessary equipment.

Correspondingly, in some examples, a manual version utilizes a piston mechanism operated by a handle to create suction for draining or pressure for filling. This design incorporates a check valve to prevent unintended fluid flow, making it reliable even without power sources and ideal for emergency situations or remote locations.

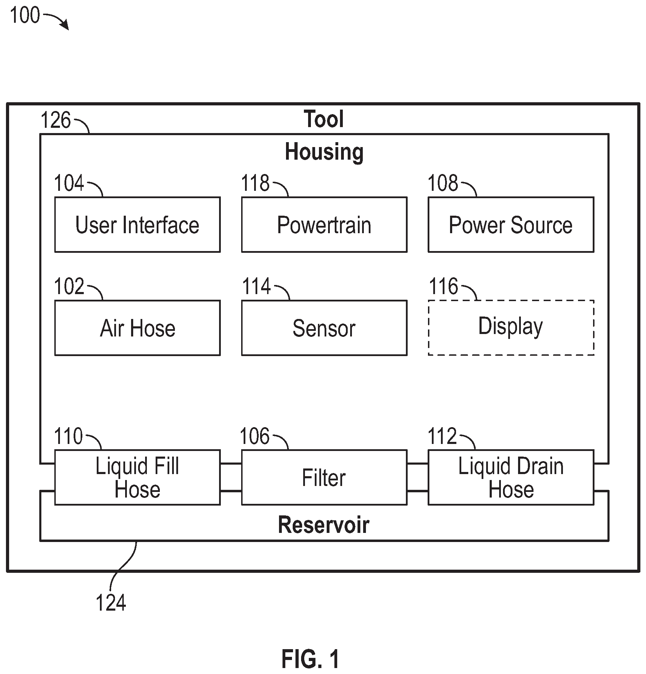

FIG. 1 shows an example of a filter maintenance tool 100 (e.g., a fill and drain tool), which may be used to assist an operator in filter maintenance (e.g., within a data center). For example, the tool 100 may be configured to drain fluid (e.g., water, coolant, etc.) from a filter and house the fluid within a reservoir (e.g., a first reservoir). Further, the tool 100 may be configured to fill the filter with fluid (e.g., from the first reservoir or a separate, second reservoir) after draining the fluid.

In some examples, the tool 100 may include a housing 126, which may be designed to be handheld to facilitate ease of use by an operator. In some examples, a reservoir 124 may be secured to the housing 126 in order to retain fluid (e.g., to retain fluid drained from the filter/supply fluid to fill the filter). In some examples, the housing 126 may house a powertrain 118 and a power source 108 of the tool 100, which may be used to drive fluid from the reservoir 124 into the filter or to drive fluid from the filter into the reservoir 125. In some examples, the powertrain 118 may be in the form of a motor, a pump, a compressor, a turbine, a motor, or any combination thereof. Further, the power source 108 may be in the form of a removable, rechargeable battery source (e.g., a lithium-ion or other battery). In other examples, the power source 108 may be an alternating current (AC) power source (e.g., a wall plug, etc.).

In some examples, the tool 100 may further include an air hose 102, which may be configured to supply air (e.g., compressed air). Correspondingly, the tool 100 may include a liquid fill hose 110 and a liquid drain hose 112, which may be configured permit a user to drain fluid from the filter (e.g., into the reservoir) and fill the filter with fluid (e.g., from the reservoir). In some examples, a filter 106 may be arranged on the liquid drain hose 112 so that fluid drained from the filter may pass through the filter 106 prior to passing into the reservoir 124. Thus, in examples where only a single reservoir is used, the fluid from the filter (e.g., drained from the filter) may be reused.

In some examples, in order to switch modes of the tool 100 between a fill mode and a drain mode, the tool 100 may include user interface 104 (e.g., a switch, button, etc.). Further, in some examples, one or more displays 116 may be arranged on the housing 126. In some examples, the displays 116 may be used in concert with one or more sensors 114. For example, the sensors 114 may be used to monitor a temperature, pressure, or other characteristic of the fluid, while the display 116 may be configured to display the temperature, volume, pressure, etc. monitored via the sensor 114. Thus, during use, an operator may be able to monitor the characteristics (e.g., temperature, pressure, volume, etc.) that are passing into or out of the filter (e.g., a filter on a coolant distribution unit in a datacenter). Thus, during maintenance, the operator may be able to fill the filter to a predetermined volume or a predetermined pressure as monitored via the display 116.

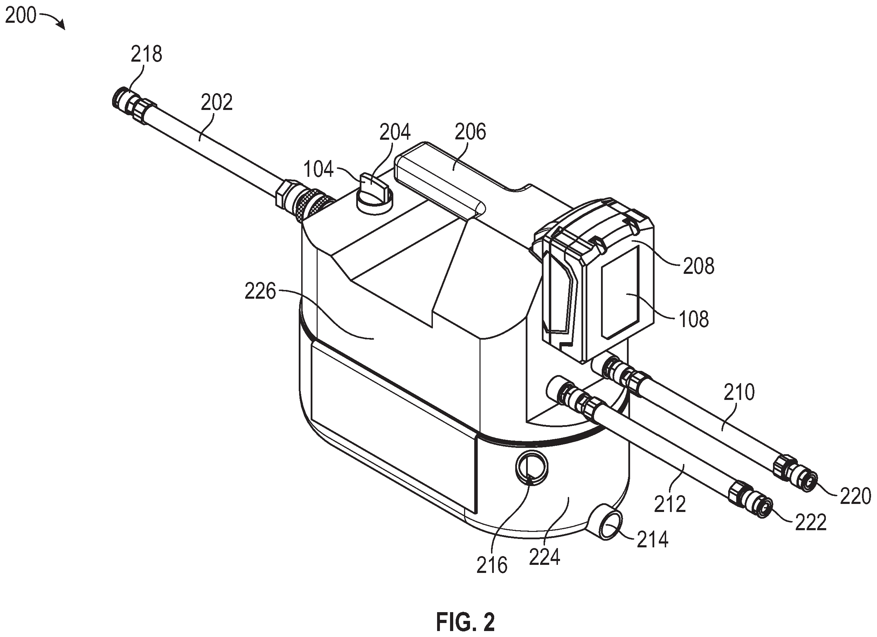

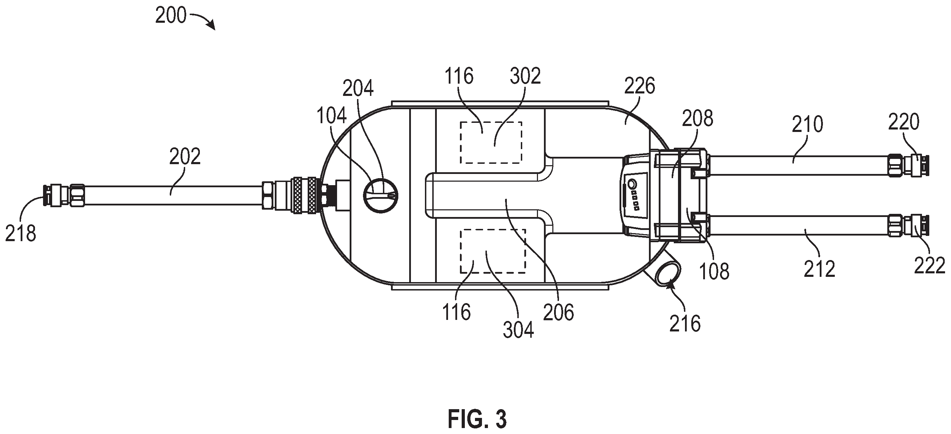

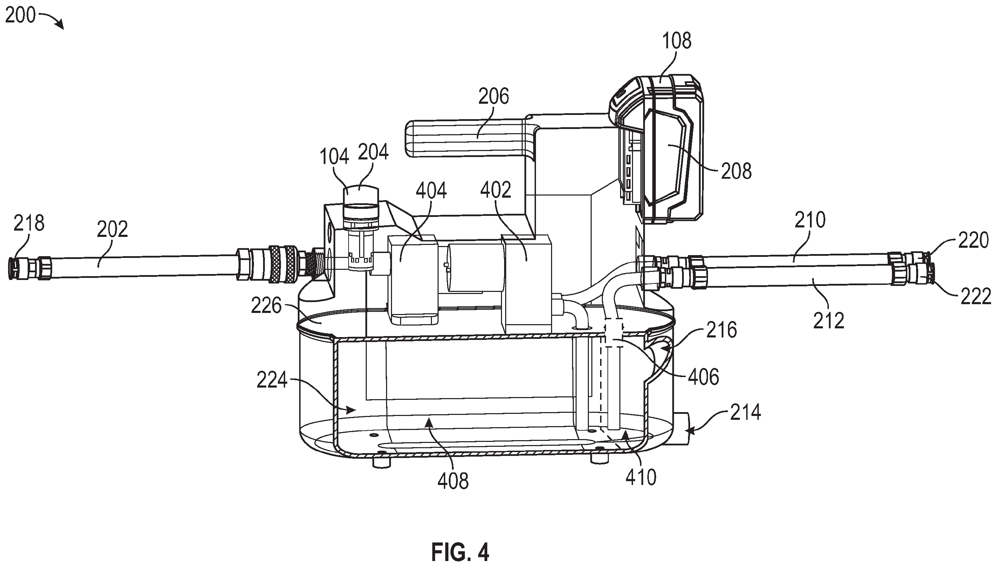

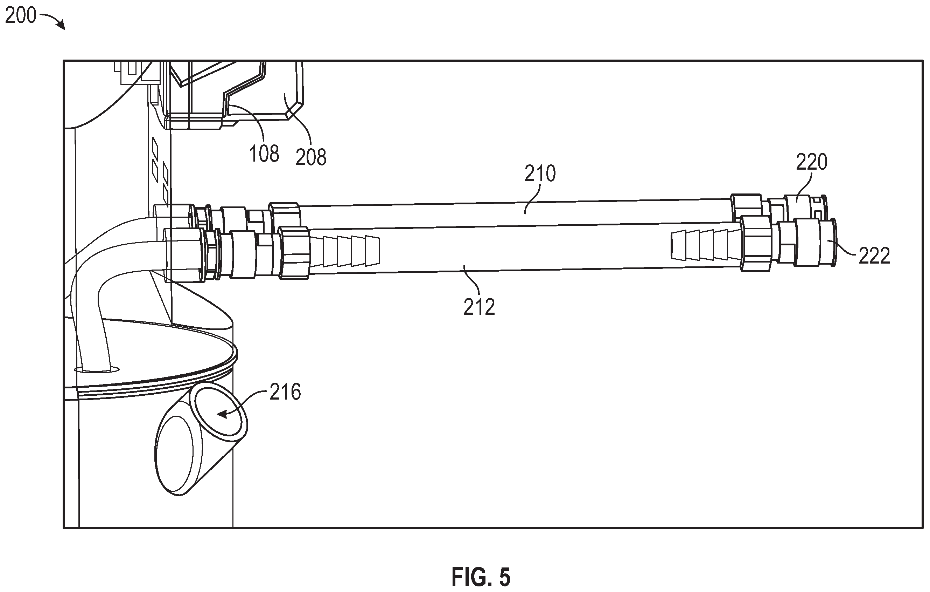

FIGS. 2-5 illustrate another example of a tool 200 (e.g., a filter maintenance tool), which can be used by an operator to perform maintenance on filters within a cooling loop of a coolant distribution unit (CDU) in a datacenter. In some examples, the tool 200 includes a housing 226 and a reservoir 224. In some examples, the reservoir 224 may be removably secured to the housing 226 (e.g., to facilitate fill/drain of the reservoir 224). In some examples, an air hose 202 extends from one end of the housing 226 and includes a fitting 218 (e.g., a quick-connect or other fitting) on an end of the air hose 202. Correspondingly, on an opposite end of the housing 226 from the air hose 202, the tool 200 may include a liquid drain hose 212 with a fitting 222 and a liquid fill hose 210 with a fitting 220. In some examples, the fittings 218, 220, 222 may be in the form of quick-connect fittings. For example, the fittings 218, 220, 222 may further be replaceable within the respective hoses, so that the fittings may be swapped by an operator to match the particular port on a filter (e.g., a filter on a CDU).

In some examples, in order to facilitate draining of a filter (e.g., of a CDU), the tool 200 may include an air compressor 404 connected to the air hose 202. Further, in order to facilitate filling of the filter (e.g., of a CDU), the tool 200 may include a pump 402 connected to the liquid fill hose 210. In some examples, to facilitate filling and draining of the filter, the tool 200 may include the liquid drain hose 212.

In some examples, to operate the tool 200 in a first mode (e.g., a filter draining mode), a switch 204 arranged on the housing may be set to a drain mode. In the drain mode, the air compressor 404 may be activated (e.g., via power from the battery 208) to pass pressurized air through the air hose 202. Thus, in use, the operator may approach the filter (e.g., of the CDU) and connect the fitting 218 of the air hose 202 to a fitting on the filter (e.g., towards a top of the filter, etc.). Following this, the operator may connect the fitting 222 of the liquid drain hose 212 to a second, different fitting on the filter. Thus, the air compressor 404 may pass pressurized air through the filter in order to force fluid (e.g., within the filter) out of the filter and through the liquid drain hose 212. In some examples, the fluid drained from the filter may pass through a filter 406 arranged on the liquid drain hose 212 and into the reservoir 224.

In some examples, to operate the tool 200 in a second mode (e.g., a filter filling mode), the switch 204 arranged on the housing may be set to a fill mode. In the fill mode, the pump 402 404 may be activated (e.g., via power from the battery 208) to pass pressurized fluid from the reservoir 224 and through the liquid fill hose 210. Thus, in use, the operator may approach the filter (e.g., of the CDU) and connect the fitting 220 of the liquid fill hose 210 to a fitting on the filter (e.g., towards a top of the filter, etc.). Following this, in some examples, the operator may connect the fitting 222 of the liquid drain hose 212 to a second, different fitting on the filter. Thus, the pump 402 may pass pressurized liquid through the filter in order to force fluid (e.g., from the reservoir 224) into the filter. In some examples, once the operator views fluid passing from the filter (e.g., back into the reservoir or passing out of a fitting on the filter), the operator may cease filling the filter.

In some examples, the reservoir 224 may be in the form of a single reservoir, which may be used to hold both fluid drained form the filer and reuse that fluid to fill a new (or the same) filter. However, in other examples, the reservoir 224 may be split into two sections (e.g., via a wall) into a first reservoir 410 and a second reservoir 408. In some examples, the first reservoir 410 can be used to retain fluid drained from the filter and the second reservoir 408 can be used for retaining fluid used to fill the filter. In some examples, the reservoir 224 may be located below the housing 226 and can be made out of optically transparent materials so that the liquid levels are visible to an operator. Further, the reservoir may include a reservoir drain port 214 located near a bottom of the reservoir 224, which may be used to drain fluid from within the reservoir 224. Correspondingly, the reservoir may include a reservoir fill port 216, which may be used as an access point for filling the reservoir 224 with liquid.

In some examples, in order to fill the filters (e.g., of the CDU) with a predetermined amount of fluid (e.g., at a predetermined pressure, temperature, or volume), the tool 200 may include one or more displays arranged on the housing. For example, the tool 200 may include an air gauge 302 to measure a pressure of the air inside of the air hose 202 (e.g., when draining the filter). Correspondingly, the tool may include a fluid gauge 304 to measure a characteristic (e.g., a pressure, volume, temperature, etc.) of fluid passing into or out of the filter.

In some examples, in order to facilitate ease of maneuverability of the tool 200, the tool may include a handle 206 that extends from the housing 226. For example, the handle 206 may be gripped by a user to move the tool 200 throughout a worksite or other location.

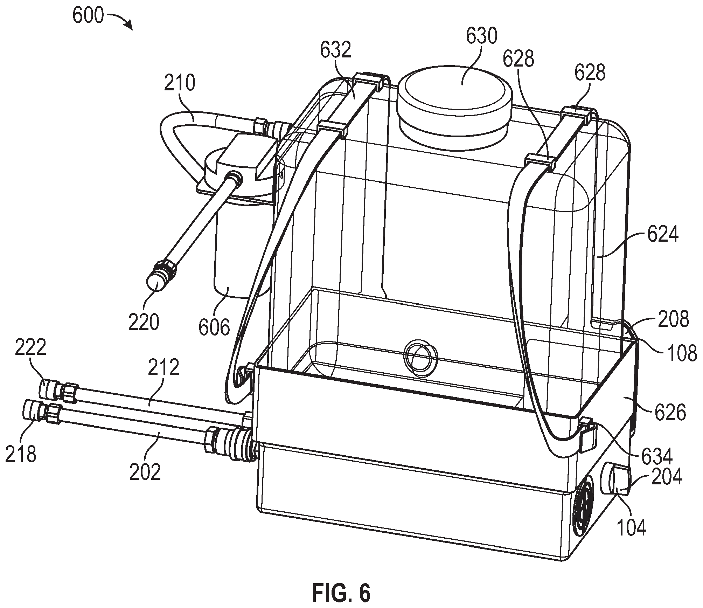

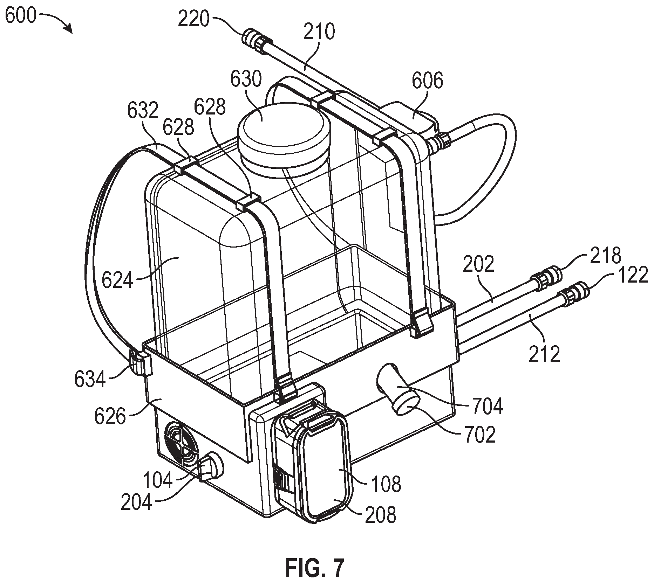

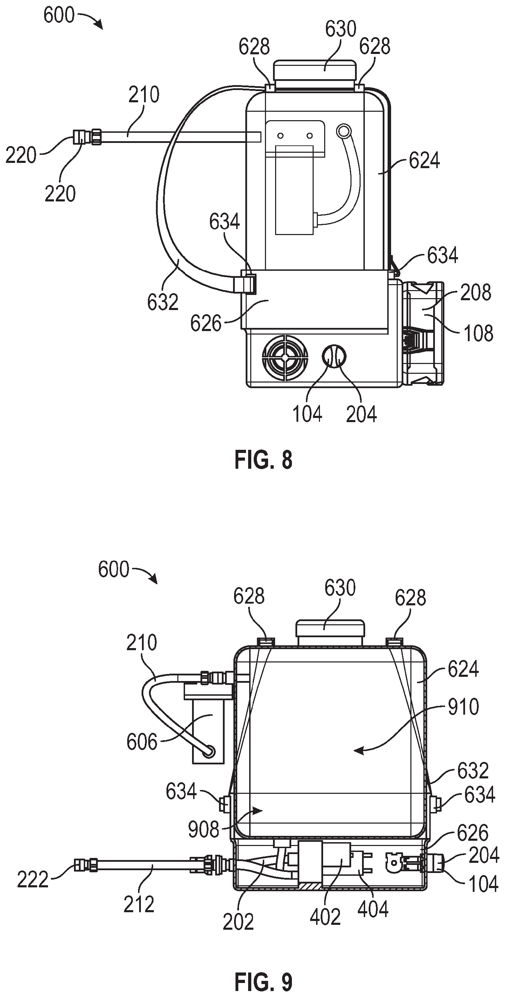

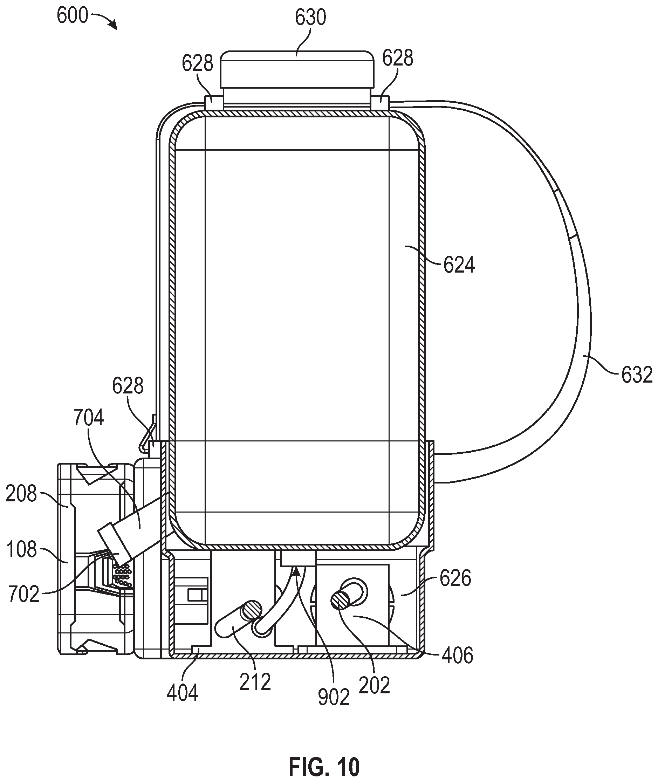

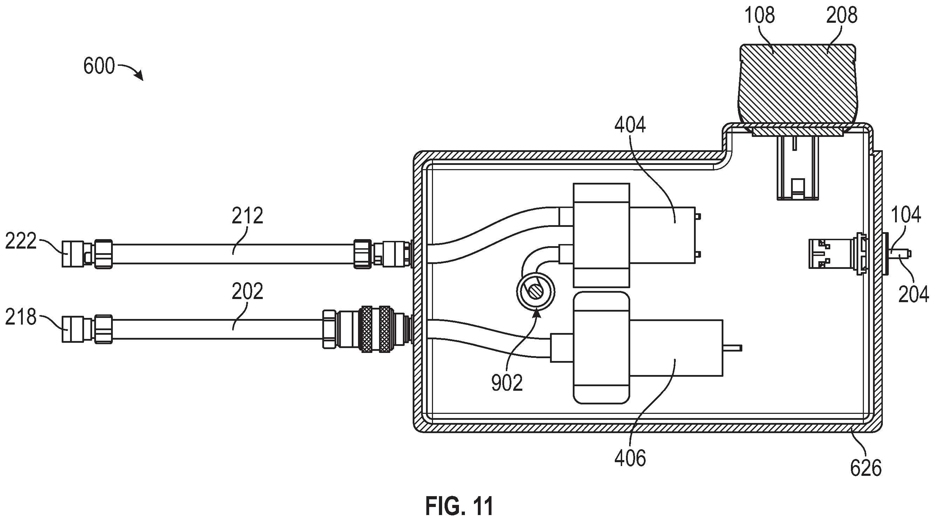

FIGS. 6-11 illustrate another example of a tool 600. As will be recognized, the tool 600 shares a number of components in common with and operates in a similar fashion to the examples illustrated and described previously (e.g., the tools 100, 200). For the sake of brevity, these common features will not be again described below in detail. Rather, previous discussion of commonly named or numbered features, unless otherwise indicated, also applies to example configurations of the tool 600.

In some examples, the tool 600 may be in the form of a backpack-type tool (e.g., physically larger than the handheld-type tool 200). Thus, the housing 626 and the reservoir 624 may be larger than the housing 226 of the tool 200 shown previously. Thus, in some examples, the tool 600 may include one or more straps 632 to facilitate transport of the tool 600. In some examples, to secure the straps 632, the tool 600 may include one or more tabs 628 molded into the reservoir 624 and one or more tabs 634 molded into the housing. In some examples, the straps 632 may be adjusted using the tabs 628, 634 to adjust a fit (e.g., length) of the straps.

In some examples, to facilitate ease of filling the reservoir 624, the reservoir 624 may include a reservoir cap 630. Correspondingly, to drain the reservoir 624, the reservoir may include a reservoir drain port 704. The reservoir drain port 704 may be angled downward and arranged through the housing 626 to facilitate draining fluid from the reservoir. Further, in some examples, the reservoir drain port 704 may include a drain cap 702 to mitigate the risk of fluid leaking from the reservoir 624.

In some examples, as mentioned above, the reservoir 624 may be in the form of a single, shared reservoir, which may include both fresh, unused fluid and used fluid (e.g., drained from the filter). However, in some examples, to filter fluid that has been drained from the filter (e.g., of the CDU), a filter 606 may be arranged on the drain hose 210. Thus, fluid forced out of the filter during the drain process (e.g., via compressed air form the air hose) may pass through the filter 606 on the drain hose 210 prior to passing into the reservoir 624, which may facilitate reuse of the fluid (e.g., when filling the filter of the CDU). However, in other examples, the reservoir 624 may be separated by a wall into two (or more) sections. For example, the reservoir 624 may be separated into a first reservoir portion 908 and a second reservoir portion 910. In some examples, the first reservoir portion 908 can be used to hold fresh, unused fluid for filling the filter of the CDU, while the second reservoir portion 910 can be used to hold, used fluid from draining the filter of the CDU.

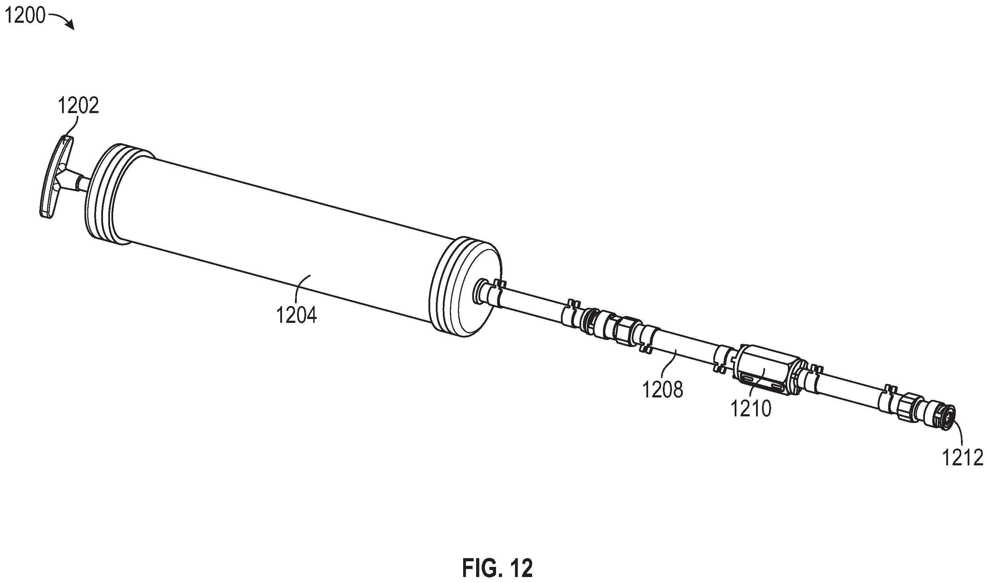

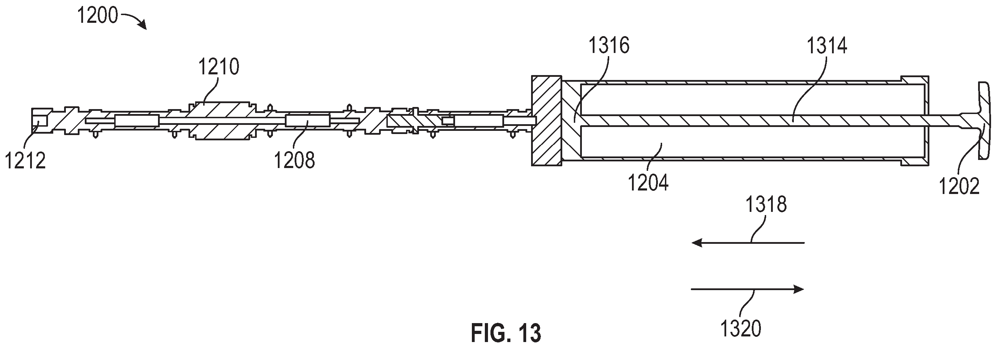

FIGS. 12 and 13 illustrate another example of a tool 1200. In some examples, unlike the tools 200, 600, the tool 1200 may be a manual fill or drain tool (e.g., without a powertrain, pump, air compressor, etc.). In some examples, the tool 1200 may include a body (e.g., forming a reservoir 1204) with a handle 1202 extending from the reservoir. In some examples, the handle 1202 may be connected to a stem 1214, which may include a piston 1216 at one end. In some examples, the piston 1216 may be configured to separate the reservoir 1204 into one or more sections depending on the position of the handle (and thus the piston).

In some examples, extending from an end of the reservoir 1204 opposite the handle 1202, the tool 1200 may include a hose 1208 (e.g., in order to facilitate fluid flow into or out of the reservoir 1204). Further, in some examples, the hose 1208 may include a check valve 1210 that may be connected in-line with the hose 1208 to permit fluid flow only when above a pressure set by the check valve (e.g., in order to mitigate leaking from the reservoir). In some examples, an end of the hose 1208 may include a fitting 1212, which may be connected to a filter (e.g., of a CDU) in order to facilitate draining or filling of the filter.

In use, in order to drain fluid from a filter (e.g., of a CDU) the user may connect the fitting 1212 to a corresponding fitting of the filter. Following this, the user may move the handle 1202 in the direction shown by arrow 1320, which may move the piston 1216 within the reservoir 1204 and draw fluid into the reservoir from the filter (e.g., via the hose 1208). Correspondingly, in order to fill the filter with fluid, the user may connect the fitting 1212 to the fitting of the filter. Following this, the user may move the handle 1202 in the direction shown by arrow 1318, which may move the piston 1216 within the reservoir 1204 and force fluid out of the reservoir into the filter (e.g., via the hose).

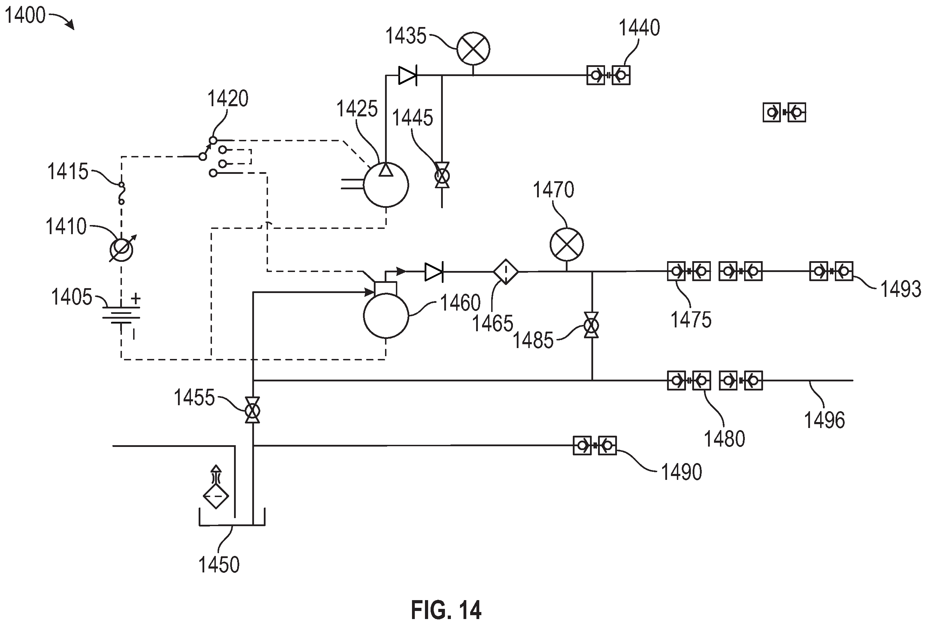

FIG. 14 illustrates an example of a tool 1400. As will be recognized, the tool 1400 shares a number of components in common with and operates in a similar fashion to the examples illustrated and described previously (e.g., the tools 100, 200). For the sake of brevity, these common features will not be again described below in detail. Rather, previous discussion of commonly named or numbered features, unless otherwise indicated, also applies to example configurations of the tool 1400. Further, it should be appreciated that, in some examples, the schematic illustration of the tool 1400 may correspond, in full or in part, to the tools described previously (e.g., the tools 100, 200, etc.).

In some examples, the filter maintenance tool 1400 can include a battery 1405 that can provide electrical power to the system. For example, the battery 1405 can be an 18V battery. The battery 1405 can be connected to a regulator 1410, which can regulate the voltage supplied by the battery 1405 to downstream components. For example, the regulator 1410 can be a 12V to 24V regulator. A fuse 1415 can be arranged in the electrical circuit to provide overcurrent protection for the system. For example, the fuse 1415 can be a 10A fuse. A switch 1420 can be provided to allow a user to select between different operating modes of the filter maintenance tool 1400, such as activating the compressor 1425 or the pump 1460. For example, the switch 1420 can be a three-way selector switch.

In some examples, the filter maintenance tool 1400 can include an air circuit for draining operations. The compressor 1425 can receive power from the switch 1420 and can generate compressed air for forcing fluid out of a filter (e.g., of a CDU). A manual valve 1445 can be arranged in the air circuit to allow an operator to vent compressed air if needed. For example, the manual valve 1445 can be a ball valve. A pressure gauge 1435 can monitor the pressure of the compressed air within the air circuit. The air circuit can terminate at an air outlet port 1440, which can be configured as a standard Schrader clip-on chuck for connection to a fitting on the filter.

In some examples, the filter maintenance tool 1400 can include a liquid circuit for filling and draining operations. A reservoir 1450 can store fluid for the system and can be configured as a vented reservoir. The reservoir 1450 can include a reservoir fill port 1490 for filling the reservoir 1450 from an external source. A manual valve 1455 can control fluid flow from the reservoir 1450 to a pump 1460. For example, the manual valve 1455 can be a ball valve. The pump 1460 can be configured as a diaphragm pump that can draw fluid from the reservoir 1450 and can pressurize the fluid for delivery to the filter. For example, the pump 1460 can be a 12V diaphragm pump. Downstream of the pump 1460, a filter 1465 can filter the fluid to remove particulates before the fluid is delivered to the filter of the CDU. A pressure gauge 1470 can monitor the pressure in the liquid circuit downstream of the filter 1465.

In some examples, the liquid circuit can include a fluid outlet port 1475 and a fluid inlet port 1480, which can be configured with quick-disconnect fittings for connection to corresponding fittings on the filter of the CDU. For example, the fluid outlet port 1475 and the fluid inlet port 1480 can be configured with Parker NSP quick-disconnect fittings. A manual valve 1485 can be arranged in the liquid circuit to control fluid flow between the fluid outlet port 1475 and the fluid inlet port 1480. For example, the manual valve 1485 can be a ball valve. In some examples, the filter maintenance tool 1400 can include a first jumper hose 1493 configured for connecting between quick-disconnect ports (e.g., between the fluid outlet port 1475, the fluid inlet port 1480, and an external port (e.g., a filter port, etc.)). For example, the first jumper hose 1493 can be a Parker NSP to Parker NSP jumper hose. A second jumper hose 1496 can be configured for connection to external equipment or containers (e.g., for draining fluid into an external container). For example, the second jumper hose 1496 can be a Parker NSP to open jumper hose.

In operation, to drain a filter using the filter maintenance tool 1400, an operator can connect the air outlet port 1440 to a first fitting on the filter and can connect the fluid inlet port 1480 to a second fitting on the filter. The operator can then activate the compressor 1425 via the switch 1420 and pass compressed air through the filter, forcing fluid out of the filter and through the fluid inlet port 1480 into the reservoir 1450. To fill a filter, the operator can connect the fluid outlet port 1475 to a fitting on the filter. The operator can then activate the pump 1460 via the switch 1420 and can open the manual valve 1455 to draw fluid from the reservoir 1450, pass the fluid through the filter 1465, and deliver the pressurized fluid through the fluid outlet port 1475 into the filter of the CDU. In some examples, the filter of the CDU may include only a single port. In such configurations, the operator can connect the fluid inlet port 1480 to the single port on the filter and can activate the pump 1460 in a reverse direction (or can use a separate vacuum function) to draw fluid from the filter into the reservoir 1450. Thus, the pump 1460 can operate to create suction through the fluid inlet port 1480, pulling fluid from the filter without requiring compressed air to force the fluid out through a separate port.

In some examples, the filter maintenance tool 1400 can be configured for use with multiple filter types within a datacenter environment. For example, the filter maintenance tool 1400 can include interchangeable fitting adapters that can be stored on the housing and can be swapped by an operator to accommodate different filter port configurations. In some examples, the filter maintenance tool 1400 can include a pressure relief valve arranged in the air circuit to prevent over-pressurization of the filter during draining operations. The pressure relief valve can be configured to open at a predetermined pressure threshold (e.g., 15 psi, 20 psi, etc.) to protect the filter and associated components from damage. In some examples, the filter maintenance tool 1400 can include a flow meter arranged in the liquid circuit to measure the volume of fluid passing through the system during fill or drain operations. The flow meter can be connected to a display on the housing to provide real-time feedback to the operator regarding the amount of fluid transferred. In some examples, the filter maintenance tool 1400 can include a timer function that can be activated via the switch 1420 to automatically shut off the compressor 1425 or the pump 1460 after a predetermined time period, which can prevent overfilling or over-draining of the filter.

In some implementations, devices or systems disclosed herein can be utilized, manufactured, or installed using methods embodying aspects of the invention. Correspondingly, any description herein of particular features, capabilities, or intended purposes of a device or system is generally intended to include disclosure of a method of using such devices for the intended purposes, a method of otherwise implementing such capabilities, a method of manufacturing relevant components of such a device or system (or the device or system as a whole), and a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as embodiments of the invention, of the utilized features and implemented capabilities of such device or system.

Features which are described in the context of separate embodiments may also be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. One or more features of the tool(s) described may be incorporated into/used in a corresponding method and vice versa.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

As used herein, unless otherwise defined or limited, directional terms are used for convenience of reference for discussion of particular figures or examples. For example, references to downward (or other) directions or top (or other) positions may be used to discuss aspects of a particular example or figure, but do not necessarily require similar orientation or geometry in all installations or configurations.

Also as used herein, unless otherwise limited or defined, "substantially parallel" indicates a direction that is within ± 12 degrees of a reference direction (e.g., within ± 6 degrees), inclusive.

Also as used herein, unless otherwise limited or defined, "substantially perpendicular" indicates a direction that is within ± 12 degrees of perpendicular a reference direction (e.g., within ± 6 degrees), inclusive.

Also as used herein, unless otherwise limited or defined, "integral" and derivatives thereof (e.g., "integrally") describe elements that are manufactured as a single piece without fasteners, adhesive, or the like to secure separate components together. For example, an element stamped, cast, or otherwise molded as a single-piece component from a single piece of sheet metal or using a single mold, without rivets, screws, or adhesive to hold separately formed pieces together is an integral (and integrally formed) element. In contrast, an element formed from multiple pieces that are separately formed initially then later connected together, is not an integral (or integrally formed) element.

Additionally, unless otherwise specified or limited, the terms "about" and "approximately," as used herein with respect to a reference value, refer to variations from the reference value of ± 15% or less, inclusive of the endpoints of the range. Similarly, the term "substantially equal" (and the like) as used herein with respect to a reference value refers to variations from the reference value of less than ± 10%, inclusive. Where specified, "substantially" can indicate in particular a variation in one numerical direction relative to a reference value. For example, "substantially less" than a reference value (and the like) indicates a value that is reduced from the reference value by 10% or more, and "substantially more" than a reference value (and the like) indicates a value that is increased from the reference value by 10% or more.

Also as used herein, unless otherwise limited or specified, "substantially identical" refers to two or more components or systems that are manufactured or used according to the same process and specification, with variation between the components or systems that are within the limitations of acceptable tolerances for the relevant process and specification. For example, two components can be considered to be substantially identical if the components are manufactured according to the same standardized manufacturing steps, with the same materials, and within the same acceptable dimensional tolerances (e.g., as specified for a particular process or product).

Unless otherwise specifically indicated, ordinal numbers are used herein for convenience of reference, based generally on the order in which particular components are presented in the relevant part of the disclosure. In this regard, for example, designations such as "first," "second," etc., generally indicate only the order in which a thus-labeled component is introduced for discussion and generally do not indicate or require a particular spatial, functional, temporal, or structural primacy or order.

The previous description of the disclosed embodiments is provided to enable any person skilled in the art to make or use the invention. Given the benefit of this disclosure, various modifications to these embodiments will be readily apparent to those skilled in the art, and the principles defined herein may be applied to other embodiments without departing from the spirit or scope of the invention. Thus, the invention is not intended to be limited to the embodiments shown herein but is to be accorded the widest scope consistent with the principles and novel features disclosed herein.

## Claims

1. A filter maintenance tool for maintaining a filter of a coolant distribution unit (CDU) in a datacenter, the filter maintenance tool comprising:
a housing;
a reservoir secured to the housing;
a powertrain housed within the housing;
a power source within the housing to power the powertrain;
an air hose extending from the housing to selectively supply compressed air to the filter of the CDU;
a liquid fill hose extending from the housing to selectively supply fluid to the filter of the CDU;
a liquid drain hose extending from the housing to drain coolant from the filter of the CDU into the reservoir; and
a user interface arranged on the housing to switch the filter maintenance tool between a fill mode and a drain mode for servicing the filter of the CDU.

2. The filter maintenance tool of claim 1, wherein the powertrain includes at least one of a motor, a pump, a compressor, or a turbine.

3. The filter maintenance tool of claim 1 or claim 2, wherein the power source is a battery.

4. The filter maintenance tool of claim 1, claim 2 or claim 3, further comprising: a filter arranged on the liquid drain hose to filter the fluid drained from the filter of the CDU.

5. The filter maintenance tool of claim 1 or of any of claims 2 to 4, further comprising: a sensor to monitor a characteristic of the fluid passing through at least one of the liquid fill hose or the liquid drain hose; and, optionally,
further comprising: a display arranged on the housing to display the characteristic monitored by the sensor; and, optionally,
wherein the characteristic includes at least one of temperature, pressure, or volume of the fluid.

6. The filter maintenance tool of claim 1 or of any of claims 2 to 5, wherein at least one of the air hose, the liquid fill hose, or the liquid drain hose includes a quick-connect fitting to removably connect to a corresponding fitting on the filter of the CDU.

7. A method of maintaining a filter of a coolant distribution unit (CDU) using a filter maintenance tool, the method comprising:
connecting an air hose of the filter maintenance tool to a first fitting on the filter;
connecting a liquid drain hose of the filter maintenance tool to a second fitting on the filter;
activating an air compressor of the filter maintenance tool to pass pressurized air through the air hose and force fluid out of the filter through the liquid drain hose; and
collecting the fluid forced out of the filter in a reservoir of the filter maintenance tool.

8. The method of claim 7, further comprising:
disconnecting the air hose from the first fitting on the filter;
connecting a liquid fill hose of the filter maintenance tool to the first fitting on the filter; and
activating a pump of the filter maintenance tool to pass fluid from the reservoir through the liquid fill hose to fill the filter.

9. The method of claim 7 or claim 8, further comprising:
filtering the fluid forced out of the filter through a second filter arranged on the liquid drain hose before collecting the fluid in the reservoir.

10. The method of claim 7, claim 8 or claim 9, further comprising:
switching the filter maintenance tool between a fill mode and a drain mode using a user interface arranged on the filter maintenance tool.

11. The method of claim 7 or of any of claims 8 to 10, wherein the reservoir includes a first reservoir portion and a second reservoir portion separated by a wall; and, optionally,
further comprising: collecting the fluid forced out of the filter in the second reservoir portion; and supplying fluid to the filter from the first reservoir portion.

12. A fill and drain tool for coolant distribution units (CDUs) in a datacenter, the fill and drain tool comprising:
a housing;
a reservoir secured to the housing;
a pump housed within the housing;
a power source within the housing to power the pump;
a fluid port extending from the housing to connect to a CDU; and
a user interface arranged on the housing to switch the fill and drain tool between a fill mode and a drain mode;
wherein in the drain mode, the pump creates suction through the fluid port to draw fluid from the CDU into the reservoir; and
wherein in the fill mode, the pump drives fluid from the reservoir through the fluid port to fill the CDU.

13. The fill and drain tool of claim 12, further comprising: a handle extending from the housing to configure the fill and drain tool as a handheld tool for transport by an operator.

14. The fill and drain tool of claim 12 or claim 13, further comprising:
a filter arranged between the fluid port and the reservoir to filter coolant drawn from the CDU before the coolant enters the reservoir.

15. The fill and drain tool of claim 12, claim 13 or claim 14, further comprising:
a compressor housed within the housing; and
an air hose extending from the housing to selectively supply compressed air to the CDU;
wherein in a secondary drain mode, the compressor passes pressurized air through the air hose to force fluid out of the CDU and into the reservoir via the fluid port; and/or
further comprising:
a pressure gauge arranged on the housing to monitor pressure within a fluid circuit of the fill and drain tool.

16. The fill and drain tool of claim 12 or of any of claims 13 to 15, wherein the reservoir includes a first reservoir portion and a second reservoir portion separated by a wall, wherein the first reservoir portion is configured to store coolant for filling the CDU and the second reservoir portion is configured to store coolant drained from the CDU.
